(19) Europäisches Patentamt
European Patent Office
Office européen des brevets

(11) **EP 4 296 779 A1**

(12) **EUROPEAN PATENT APPLICATION**

(43) Date of publication:
**27.12.2023 Bulletin 2023/52**

(21) Application number: **22180144.2**

(22) Date of filing: **21.06.2022**

(51) International Patent Classification (IPC):
**G03F 7/20** (2006.01)  **G01N 23/201** (2018.01)

(52) Cooperative Patent Classification (CPC):
**G03F 7/70616; G01N 23/201**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventor: **NIENHUYS, Han-Kwang**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD FOR ALIGNING AN ILLUMINATION-DETECTION SYSTEM OF A METROLOGY DEVICE AND ASSOCIATED METROLOGY DEVICE**

(57) Disclosed is a method of determining an illumination-detection system alignment of an illumination-detection system describing alignment of at least one detector and/or measurement illumination of a metrology apparatus in terms of two or more illumination-detection system alignment parameters, each illumination-detection system alignment parameter relating to a respective degree of freedom for aligning the detector and/or the measurement illumination. The method comprises obtaining a diffraction pattern relating to diffraction of broadband radiation from a structure; transforming each of one or more diffraction orders of the diffraction pattern to a respective region coordinate system, each region coordinate system comprising a first axis and a second axis, each region coordinate system being such that said first axis is aligned in relation to a direction of an intensity metric of each transformed diffraction order; and determining illumination-detection system alignment parameter values for the illumination-detection system alignment parameters.

Fig. 8

**Description**

<u>FIELD</u>

The present invention relates to metrology applications in the manufacture of integrated circuits.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

To perform metrology using broadband SXR radiation, it is necessary to determine the alignment of an illumination-detection system of the metrology device; e.g., alignment of a detector of the metrology device and/or the measurement radiation with respect to the target. A diffraction pattern may comprise curved lines having a curvature dependent on the detector alignment. The diffraction orders are spectrally dispersed over these curved lines with the wavelength initially unknown for each point on the curve.

It would be desirable to improve on present detector alignment methods.

SUMMARY

In a first aspect of the invention there is provided a method of determining an illumination-detection system alignment of an illumination-detection system describing alignment of at least one detector and/or measurement illumination of a metrology apparatus in terms of two or more illumination-detection system alignment parameters, each illumination-detection system alignment parameter relating to a respective degree of freedom for aligning the detector and/or the measurement illumination; the method comprising: obtaining a diffraction pattern relating to diffraction of broadband radiation from a structure; transforming each of one or more diffraction orders of the diffraction pattern to a respective region coordinate system, each region coordinate system comprising a first axis and a second axis, each region coordinate system being such that said first axis is aligned in relation to a direction of an intensity metric of each transformed diffraction order; and determining illumination-detection system alignment parameter values for the illumination-detection system alignment parameters such that the position of said intensity metric of each said diffraction pattern substantially corresponds to an expected configuration in said region coordinate system.

The above and other aspects of the invention will be understood from a consideration of the examples described below.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 depicts a schematic representation of a metrology apparatus in which EUV and/or SXR radiation is used;
- Figure 6 depicts a simplified schematic drawing of an illumination source, which may be the illumination source for high harmonic generation for a metrology apparatus such as that illustrated in Figure 5;
- Figure 7 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 8 is a schematic illustration of a metrology apparatus of known configuration; and
- Figure 9 is an illustration of a two-dimensional (2D) diffraction pattern as may be obtained using a metrology apparatus such as illustrated in Figure 8;
- Figure 10 is an illustration of a 2D diffraction pattern transformed into pupil coordinates;
- Figure 11 is a flowchart describing a method according to an embodiment;
- Figure 12 illustrates the assigning of a region of interest to a single diffraction order as performed in the method of Figure 11;
- Figure 13 is a 4D plot of two-dimensional pupil space against two-dimensional region space corresponding to a region of interest, with peak intensity values for a diffraction order plotted thereon; and
- Figure 14 is a plot of peak intensity values in two-dimensional region space and partial derivatives thereof.

DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

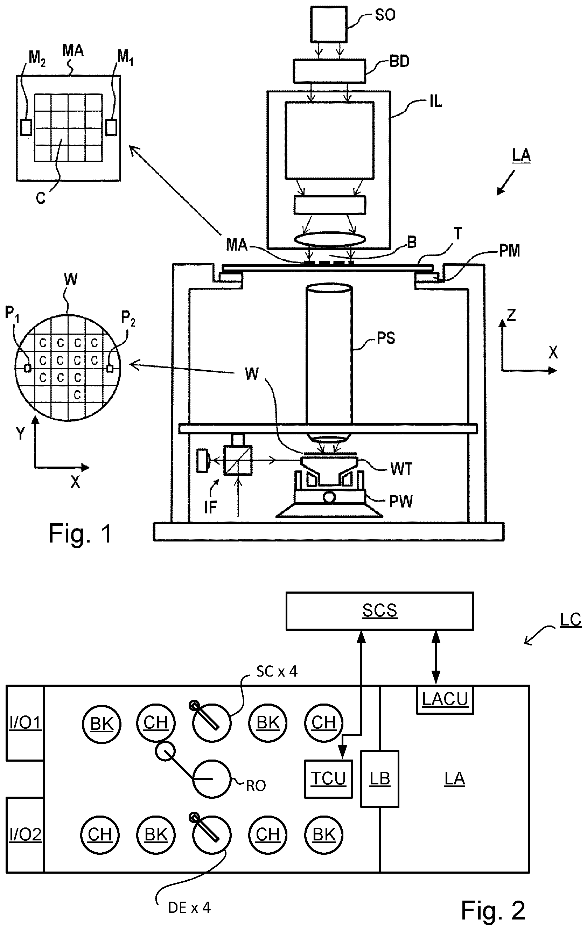

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered, which may be diffracted, reflected or transmitted, radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets may behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

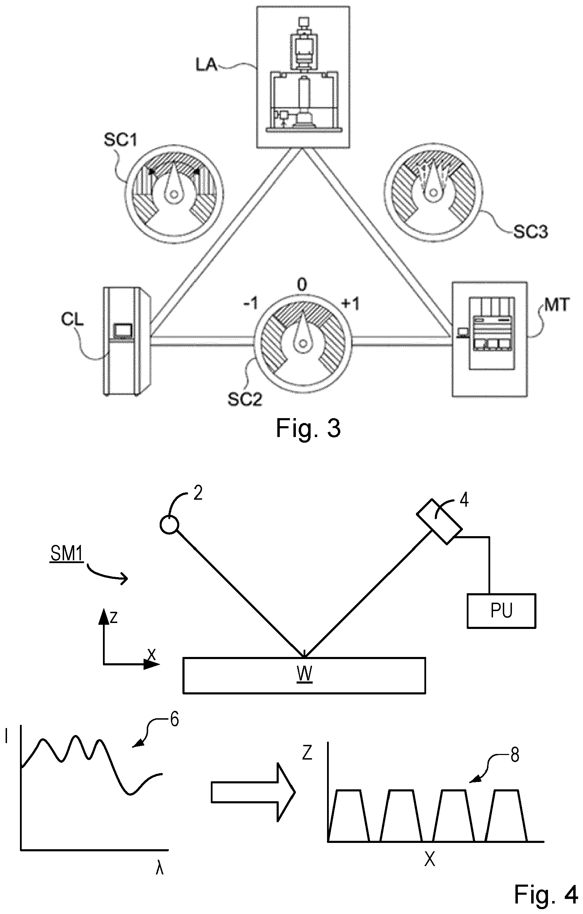

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil-based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray, extreme ultraviolet and visible to near-IR wave range.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Another embodiment is a transmissive version of the example of a metrology apparatus, such as a scatterometer shown in Figure 4. The transmitted radiation is passed to a spectrometer detector, which measures a spectrum as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

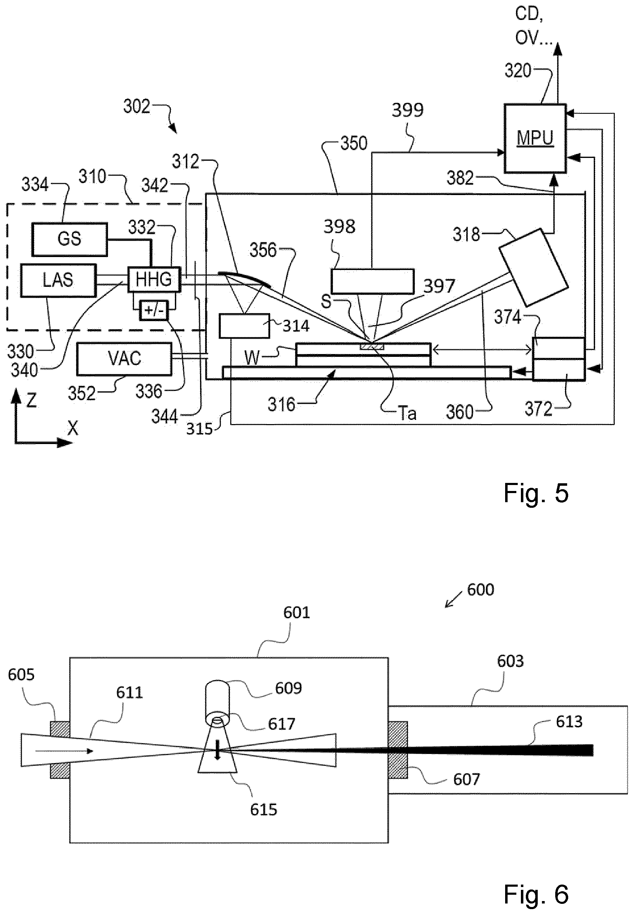

Figure 5 depicts a schematic representation of a metrology apparatus 302 in which the aforementioned radiation may be used to measure parameters of structures on a substrate. The metrology apparatus 302 presented in Figure 5 may be suitable for the hard X-ray, soft X-rays and/or EUV domain.

Figure 5 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10$\mu$m, for example in the region of 1 $\mu$m (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen ($N_2$), Oxygen ($O_2$), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths may, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 $\mu$m in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 5, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 5 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths a range from 0.01 nm to 100 nm, optionally from 0.1 nm to 100 nm, optionally from 1 nm to 100 nm, optionally from 1 nm to 50 nm, or optionally from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

Figure 6 shows a simplified schematic drawing of an embodiment 600 of an illumination source 310, which may be the illumination source for high harmonic generation (HHG). One or more of the features of the illumination source in the metrology tool described with respect to Figures 5 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 5. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which may comprise an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 5. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607, e.g. an aperture or window, and may be subsequently manipulated and directed by an illumination system 603, which may be an example of the illumination system 312 in Figure 5, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 6 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation may be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

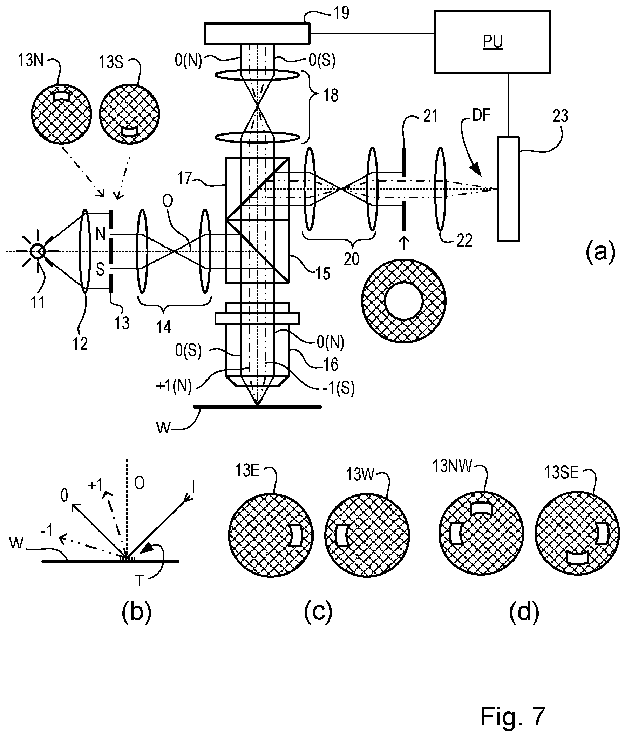

A further metrology apparatus suitable for use in embodiments of the invention is shown in Figure 7(a). Note that this is only one example of a suitable metrology apparatus. An alternative suitable metrology apparatus may use EUV radiation such as, for example, that disclosed in WO2017/186483A1. A target structure T and diffracted rays of measurement radiation used to illuminate the target structure are illustrated in more detail in Figure 7(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode may interfere with the desired measurement signals.

As shown in Figure 7(b), target structure T is placed with substrate W normal to the optical axis O of objective lens 16. The substrate W may be supported by a support (not shown). A ray of measurement radiation I (e.g., comprising SXR wavelengths) impinging on target structure T from an angle off the axis O gives rise to a zeroth order ray (solid line 0) and two first order rays (dot-chain line +1 and double dot-chain line -1). It should be remembered that with an overfilled small target structure, these rays are just one of many parallel rays covering the area of the substrate including metrology target structure T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 7(a) and 7(b) are shown somewhat off axis, purely to enable them to be more easily distinguished in the diagram.

At least the 0 and +1 orders diffracted by the target structure T on substrate W are collected by objective lens 16 and directed back through beam splitter 15. Returning to Figure 7(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target structure T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

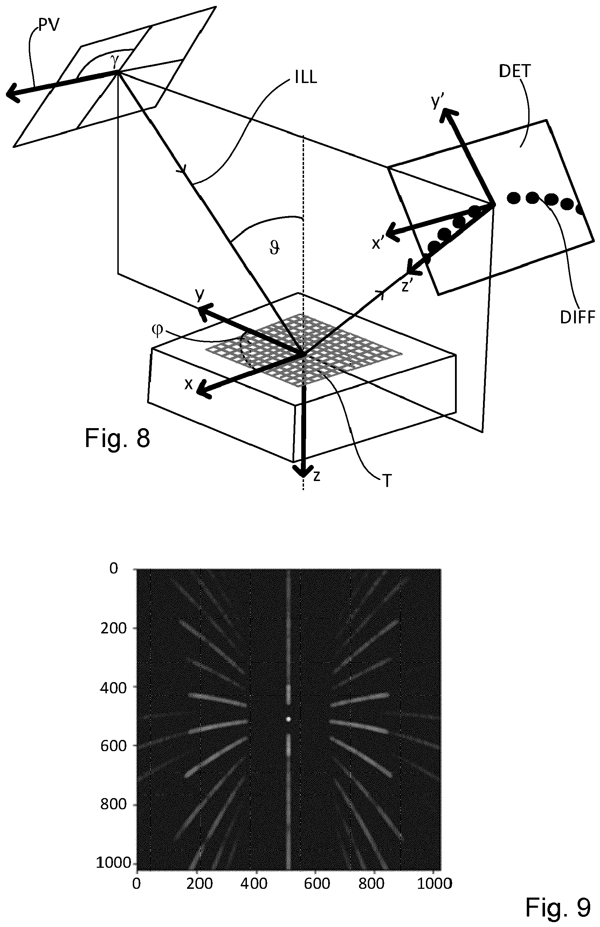

Figure 8 is a schematic drawing of an example measurement using an SXR metrology device such as illustrated in Figure 5. In SXR metrology, a beam of SXR radiation ILL (e.g., in the 10-20 nm wavelength range) may be used to illuminate a structure or target T (in a structure plane or target plane). The diffraction pattern DIFF is captured by (at least one) detector DET, which may be an image sensor, for example a CCD or CMOS image sensor. The target T coordinate system is labelled x, y, z (where x and y describe the structure plane/target plane) and the detector coordinate system is labelled x', y', z'. The illumination angle of incidence is labelled $\vartheta$, the illumination azimuth angle is labelled $\varphi$. The illumination polarization vector PV has a polarization angle y. The detector DET may in fact comprise two or more detectors which are not necessarily co-planar.

Figure 9 is an example two-dimensional (2D) diffraction image as may be captured on detector DET. In this specific example, the x and y axes are labeled in terms of pixels (e.g., a 1024x1024 pixel detector). The detector specifics are of course purely an example. As can be seen, a number of the diffraction orders comprise curved lines, with a curvature dependent on orientation and position of the detector DET. In particular, it is desirable to find the wavelength value for each detector position (pixel). To do this, the actual position of detector in space should be determined.

For some physics-based parameter inference methods (as opposed to data-driven ones), it is necessary to map pixel coordinates to wavelengths. If the pixel coordinates ($x',y'$) can be transformed to target coordinates ($x, y, z$) as in Figure 8, and the target pitches ($p_x, p_y$) are known, this mapping is possible. Because of manufacturing tolerances and possible drifts, the alignment of the detector with respect to a pupil plane of the system is not known with sufficient accuracy. This alignment is required in order to perform the mapping. There is 6 degrees of freedom for the mapping (i.e., the 6 degrees of freedom for the detector alignment). These degrees of freedom comprise the three directions of the detector coordinate system x', y', z' and rotations around each of these directions $R_{x'}, R_{y'}, R_{z'}$. The alignment of the beam of SXR radiation ILL may add up to two additional degrees of freedom, illumination alignment degrees of freedom: illumination azimuth $\varphi$ and illumination angle of incidence $\vartheta$. As such, there may be up to 8 degrees of freedom in total for the combined illumination-detection system.

In one known example, it is known that two degrees of freedom of the mapping can be eliminated by centering the zeroth order (the bright spot in the center of the pattern in Figure 9). However, this only works if the zeroth order is captured on the same sensor as the higher-order diffraction (which may not be desirable because it would not allow for measuring the spectrum of the zeroth order radiation) and is not saturating the detector. For targets with 2D-periodic diffraction unit cells (such as the target T of Figure 8), there is typically insufficient dynamic range to capture both the higher orders and an unsaturated zeroth order. Additionally, this method only eliminates two of the six degrees of freedom for detector alignment and the eight degrees of freedom for illumination-detection system alignment. The "ID" and "2D" in this context relate to directions of periodicity: i.e., a one-dimensional (1D) periodic structure is periodic (repeating) in one direction and a 2D periodic structure is periodic (repeating) in two dimensions, as such, 1D periodic structures may comprise line patterns (e.g., line-space gratings) and 2D periodic structures may comprise block patterns.

Another known method for performing this mapping uses a special fiducial target (not on the wafer) to calibrate the sensor position. However, the fact that this fiducial is not on the same wafer as the metrology targets being measured introduces a new calibration problem: the alignment of the fiducial relative to the customer target.

Even for data-driven methods, a first preprocessing step may typically comprise a mapping of the signal (image data $f(x, y)$) to an antisymmetric component $A(x, y)$ and symmetric component $S(x, y)$, e.g.:

$$A(x,y) = f(x,y) - f(2x_0 - x, y), \quad S(x,y) = f(x,y) + f(2x_0 - x, y).$$

where $x_0$ is the target center in the x direction. Most of the overlay response tends to be in the antisymmetric component $A(x, y)$; if the target center $x_0$ is not accurately known, the overlay signal may be swamped by an alignment-error signal.

A method will be disclosed for determining illumination-detection system alignment (e.g., with respect to a pupil plane of the metrology tool) according to at least a subset of the applicable degrees of freedom; e.g., at least 2, at least 3, at least 4, at least 5 at least 6, at least 7 or at least 8 of the possible degrees of freedom of the illumination-detection system alignment or at least 2, at least 3, at least 4, at least 5 at least 6 of the detector alignment degrees of freedom. Where there is more than one detector without a fixed relationship between the detectors, the subset of degrees of freedom relating to detector position may be determined for per detector (e.g., there may be a possible 6 detector position degrees of freedom per detector), such that describing the subset as comprising three detector position degrees of freedom may be understood to describe the same three detector position degrees of freedom per detector.

Depending on the detection numerical aperture (NA) of the tool, the proposed method can robustly and quickly fit at least three degrees of freedom ($R_{z'}$, x', y') for rotation and translation in detector coordinates. These are the more important degrees of freedom in mapping the pixel coordinates to target coordinates. With a sufficiently large NA, more degrees of freedom can be fitted, i.e., one or more of ($R_{x'}$, $R_{y'}$, z'), and/or optionally the illumination alignment degrees of freedom: illumination azimuth $\varphi$ and illumination angle of incidence $\vartheta$.

The method may comprise fitting illumination-detection system alignment parameters (each illumination-detection system alignment parameter corresponding with one of said degrees of freedom) until the peaks of the diffraction pattern correspond to the expected locations for the diffraction orders, or more generally till the position of an intensity metric such as peak intensity of each said diffraction pattern substantially corresponds to an expected configuration. This would be fairly straightforward if the (e.g., SXR) source radiation were monochromatic. In such as case each diffraction order results in a discrete spot on the detector with a known diffraction order ($m_x$, $m_y$); the spot positions could then be described as $x'[m_x, m_y]$, $y'[m_x, m_y]$, with a 6-parameter model used to calculate these.

However, the concepts described herein relate to broadband (e.g., SXR) radiation rather than monochromatic radiation. Rather than spots, curved lines are obtained (as evidenced by Figure 9), with the curvature dependent on the detector alignment. The diffraction orders are spectrally dispersed over these curved lines. Each point on these curves is therefore now parametrized by wavelength $\lambda$, i.e., they can be calculated as $x'(m_x, m_y, \lambda)$ and $y'(m_x, m_y, \lambda)$. However, the wavelength $\lambda$ is initially unknown for each point on the curve.

In an embodiment, the method may comprise eliminating the unknown wavelengths and transforming the fitting problem to fitting data $X_i$, $Y_i$ to a function $Y = F(X)$, where F depends on the illumination-detection system alignment parameters. In this way, a parametric fit may be transformed to a least-squares fit.

In an embodiment, the method may use a transformation from detector space to a pupil space ($k_x$, $k_y$). These are the x and y components of a unit vector of a ray emitted by the target, where x, y, z are in target coordinates, i.e., attached to the target unit cell. The detector position may be described by a rotation matrix Q and a position vector $r_0$ in target coordinates; the relation of a vector with a position r' in detector coordinates and a vector r in target coordinates may be given by the transformations:

$$r = T(r') = Q \cdot r' + r_0, \quad r' = T^{-1}(r) = Q^{-1} \cdot (r - r_0), \quad (eq.\ 1)$$

The rotation matrix Q can be written as the product of rotation matrices:

$$Q = Q_z\, Q_0\, Q'_x\, Q'_y\, Q'_z, \quad (eq.\ 2)$$

where $Q_0$ is the rotation matrix for the nominal detector position, $Q'_x$, $Q'_y$, $Q'_z$ are rotation matrices for small angle rotations (for example, a few milliradians) along the detector x', y', z' axes (representing alignment errors), and $Q_z$ represents target rotations, for example by a multiple of 90 degrees along the target z axis. The matrices $Q'_x$, $Q'_y$, $Q'_z$ (hereafter in shortened notation $Q'_{xyz}$) are identity matrices in the absence of alignment errors. Their order is arbitrary; the choice of order may only have a small impact if the alignment errors are small (milliradians or less).

The intersection of a ray with unit vector k (emitted from the origin) with the detector plane (given Q and r) is calculated.

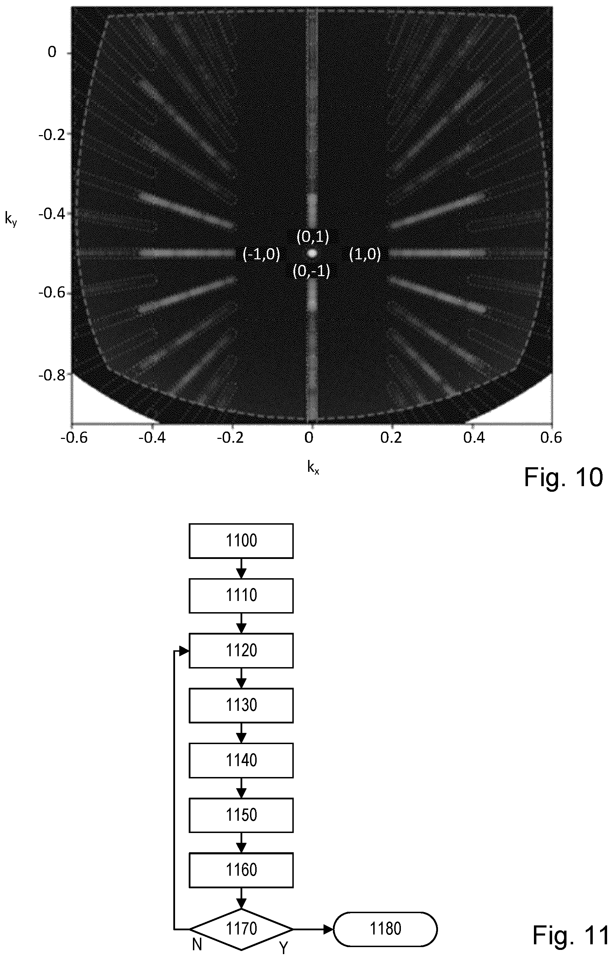

Figure 10 is an example of a 2D diffraction pattern in pupil coordinates. Given target pitches ($p_x$, $p_y$), diffraction orders ($m_x$, $m_y$), and wavelength $\lambda$, the pupil coordinates may be calculated as:

$$\left(k_x, k_y\right) = \left(k_{0x} + \frac{m_x\lambda}{p_x}, k_{0y} + \frac{m_y\lambda}{p_y}\right), \quad (eq.\ 3)$$

where ($k_{0x}$, $k_{0y}$) are the pupil coordinates of the illumination (or equivalently the of the zeroth order diffraction/specular reflection). If the unit cell of the target is not rectangular, but rather is a parallelogram, there will be primitive translation vectors $\boldsymbol{p_1}$, $\boldsymbol{p_2}$ and eq. 3 would need to be modified.

In addition, the transformation P from wavelength and diffraction-order number to pupil coordinate-vector may be defined as:

$$\boldsymbol{k} = P\big(m_x, m_y, \lambda; Q, \boldsymbol{r_0}\big), \quad (\text{eq. 4})$$

Figure 11 is a flowchart describing a method for implementing the concepts disclosed herein. Such a method may determine two or more illumination-detection system alignment parameters out of the eight illumination-detection system alignment parameters. The eight illumination-detection system alignment parameters may comprise the six detector alignment parameters (e.g., per detector where appropriate) and the two illumination alignment parameters (illumination azimuth $\varphi$ and illumination angle of incidence $\vartheta$), where the detector alignment parameters comprise three parameters for the detector position $\boldsymbol{r_0}$ (i.e., its x, y, and z components) and the three rotation angles $\alpha_x, \alpha_y, \alpha_z$ that generate the rotation matrices $Q'_{xyz}$. The steps are as follows:

At step 1100, a diffraction pattern is obtained as an image $f(x', y')$ in detector coordinates, the diffraction pattern being related to (e.g., obtained by measurement of) a target with known pitches ($p_x$, $p_y$), using an SXR source with an approximately known wavelength range $\lambda_a < \lambda < \lambda_b$. Optionally, wavelength $\lambda_b$ may be chosen as an integer multiple of the longest wavelength in the SXR source; for example two times the longest wavelength. This can prevent having to accommodate for overlapping diffraction orders, as it can be appreciated from Figure 10 that a region of interest for the diffraction order (2, 0) is an extension of diffraction order (1, 0).

At step 1110, an initial estimate (nominal values) for at least the detection alignment parameters $\boldsymbol{r_0}$ and $\alpha_{xyz}$ is defined (e.g., up to six values in total; the angles may be assumed to have nominal values of zero). The initial estimate (nominal values) may also be defined for the illumination alignment parameters illumination azimuth $\varphi$ and illumination angle of incidence $\vartheta$.

At step 1120, using these parameters, the image may be transformed to pupil coordinates, resulting in a function $g(k_x, k_y)$, such as illustrated by Figure 10. Note that in Figure 10, the diffraction orders are substantially straight, which would indicate that the mapping is accurate and the detector position is already well-defined. It may be that, in the first iteration of this method, these diffraction orders would be less straight than illustrated here.

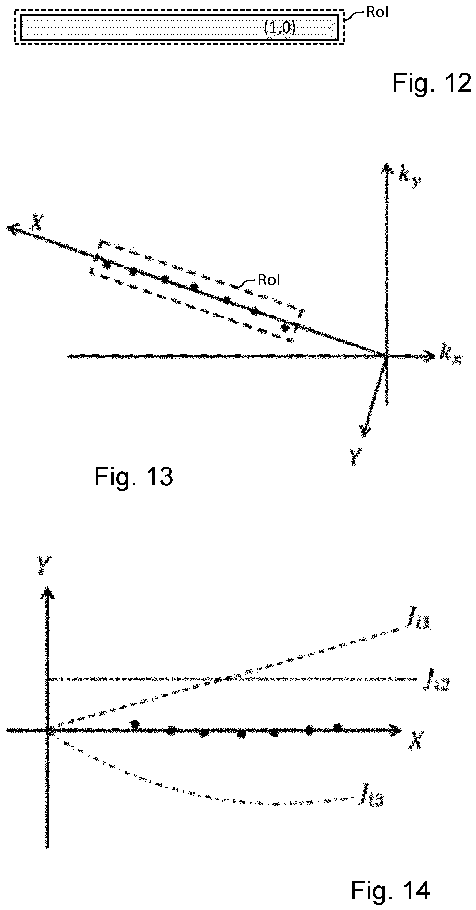

At step 1130 regions of interest (e.g., rectangular regions of interest) may be assigned in pupil space ($k_x$, $k_y$ space), such that a respective region of interest is assigned to each of one or more of the transformed diffraction orders. The regions of interest may be defined using Equation eq.3 above. The regions of interest may be large enough so that the diffraction intensity of its respective diffraction order is fully contained within the region (e.g., rectangle); the amount of additional space or margin may depend on the SXR beam divergence and the expected alignment error. Figure 12 shows a single diffraction order (1, 0) and its respective exemplary region of interest (ROI).

This step may be performed on all imaged diffraction orders or a subset of these (e.g., one or more, two or more, three or more, four or more, six or more or eight or more diffraction orders). Where only a subset is chosen, they may comprise the strongest (highest intensity) of the imaged orders. As such, in an embodiment, the selected orders may comprise at least any three of the four orders ($\pm$1,0) and (0, $\pm$1), i.e., the labeled orders on Figure 10.

At step 1140, a region coordinate system XY for each of the regions of interest is defined. The region coordinate system may be such that an intensity metric such as the peak intensity (peak diffraction intensity) lies on the X-axis, i.e., at Y = 0, if the alignment parameters (e.g., Q and $\boldsymbol{r_0}$) are correct. More generally, the X-axis or first axis may be aligned in relation to (e.g., to be parallel to or aligned on) a direction of the intensity metric. While it is convenient to define the X-axis such that the intensity metric lies on this axis, the X-axis may instead be aligned on an edge of the rectangular region rather than in the center. This would require only a trivial modification of the method. In any case, this step may comprise mapping $g(k_x, k_y)$ to new function $h(X, Y)$.

The coordinates ($X_i$, $Y_i$) for a number of diffraction peaks may be obtained. In an embodiment, this may comprise converting $h(X_i, Y)$ to a value $Y_i$, for example as the weighted mean (center of mass) along Y for example, by preselecting $X_i$ and evaluating:

$$Y_i = \frac{\int h(X_i, Y)\, Y \, dY}{\int h(X_i, Y) dY},$$

where the integration limits cover the inside of the region. Figure 13 is a plot of $k_x$, $k_y$ and $X$, $Y$, illustrating such a

transformation. The $X_i$, $Y_i$ values for each of the regions can then be combined; for example if each of four regions is sampled at 100 $X_i$ values, then $i = 1, ... ,400$. In Figure 13, there are 7 $X_i$ values. The total number of $X_i$ values over all regions combined in general is not smaller than the number of alignment parameters.

It can be appreciated that the mapping of $h(X_i, Y)$ describes a mapping only within one region; a full mapping of the pupil may be described by $h(m_x, m_y, X, Y)$ where $m_x$, $m_y$ are a pair of integers identifying the region. Therefore, rather than mapping each region individually and combining afterwards, the mapping may be achieved by preselecting $X_i$ and evaluating:

$$Y_i = \frac{\int h(m_x, m_y, X, Y)\, Y\, dY}{\int h(m_x, m_y, X, Y)\, dY}$$

Optionally, at this step, a standard error $\sigma_i$ may be assigned to each $Y_i$ value, for example:

$$\sigma_i = \frac{1}{\sqrt{\int h(X_i, Y)\, dY}}.$$

(Only the ratios of standard errors may be used; a normalization factor is left out here.).

There are alternatives to mapping as a weighted mean along Y. These include mapping as:

- the median along Y;
- the modus (peak position) along Y;
- a value obtained by fitting to a function describing a known peak shape $T(Y)$, for example a least squares fit of $b \times T(Y - Y_i)$ with $b$, $Y_i$ as fit parameters. This may be useful if the beam profile is known to be asymmetric, i.e., $T(Y) \neq T(-Y)$. The function $T$ may be chosen to be dependent on the diffraction order number, i.e., $T(m_x, m_y, Y)$. It may be chosen to be dependent on the $X$ coordinate, i.e. $T(m_x, m_y, X, Y)$.

Generally, the mapping may be expressed as:

$$Y_i = F(a, X_i, m_{xi}, m_{yi})$$

where F is a function that implicitly depends on the full diffraction pattern $f(x', y')$ and target pitches $p_x$, $p_y$. Each $X_i$ value is accompanied by the diffraction order numbers $m_{xi}$ and $m_{yi}$. This function can be constructed using an interpolation, e.g., in a similar to that described in step 1150 below.

At step 1150, a Jacobian $J_{ij}$ of partial derivatives describing the sensitivity of Y with each alignment parameter may be constructed as:

$$J_{ij} = \frac{\partial Y_i}{\partial a_j},$$

where the components of the vector $a$ are the detector alignment parameters: e.g., the three components of $r_0$ and the three angles $\alpha_{xyz}$ and optionally the illumination alignment parameters, or a subset of these six or eight parameters ($j=1$ to $m$, where $m$ is the number of alignment parameters being optimized). This Jacobian may be constructed by application of Equation eq.4 above, for example. A practical implementation of this step may comprise generating a different set of X values for a range of wavelengths, calculate the partial derivatives using finite differencing, and interpolating to obtain values for $Y_i$ for the $X_i$ values from step 1140.

At step 1160, a correction $\Delta a$ for the detector alignment parameters may be estimated by least-squares solving for $\Delta a$:

$$\sum_j J_{ij} \Delta a_j = Y_i.$$

Optionally the standard errors $\sigma_i$ described in step 1030 may be used to perform a weighted least-squares. Steps 1150 and 1160 are schematically illustrated by the plot of Y against X of Figure 14.

The new detector alignment parameter estimate may then be determined as:

$$a := a + \Delta a.$$

At step 1170 it may be determined whether convergence has been reached, if not the method may return to step 1120 and a further iteration of steps 1120 to 1170 performed using the new detector alignment parameter estimate. If convergence is reached, then the method stops and the final alignment parameter estimate used to define the detector position for any mapping. This convergence may be such that a position of the intensity metric of each said diffraction pattern substantially corresponds to an expected configuration in said region coordinate system (e.g., aligned on or with (e.g., parallel to) the X-axis).

Steps 1150 to 1170 describe a method of fitting the up to six detector alignment parameters and optionally a further one or two illumination alignment parameters in the *a* vector. This method is a particular implementation of a least-squares fit that minimizes the sum of squares:

$$SS(a) = \sum_i \left( \frac{F(a, X_i, m_{xi}, m_{yi})}{\sigma_i} \right)^2 .$$

The standard errors $\sigma_i$ can be taken constant (e.g. all $\sigma_i$ = 1) or may be estimated as optionally described in step 1140. There are many well-known algorithms to do such a minimization; for example: the Levenberg-Marquardt algorithm, the Nelder-Mead method, and the Gauss-Newton algorithm. Steps 1150 to 1170 actually describe a variant of the Gauss-Newton algorithm.

Least-squares algorithms (i.e., minimizing S above) are commonly used because they are fast. Metrics other than the "sum of squares" for minimizing (close to zero) exist and may be used in the methods disclosed herein. For example, Bayesian methods can be used if there is prior knowledge of the probability distribution of the *a* vector. In particular if a least-squares fit of all six degrees of freedom in *a* leads to unrealistic results, Bayesian inference (optionally with a Gaussian prior on *a*) can be used.

The more conventional notation of a least-squares curve fit is to minimize:

$$S(a) = \sum_i \left( \frac{F'(a, X_i, m_{xi}, m_{yi}) - Y_i}{\sigma_i} \right)^2$$

where the prime in F' indicates that this is a different function from F as discussed above. This could also be used to find *a*, but the entire step-by-step process would need to be modified as follows:

- Obtain $f(x', y')$ [as before].
- Start with an initial guess of *a*; call this $a_0$.
- Transform $f(x', y')$ to $g(k_x, k_y)$ using $a_0$.
- Assign regions of interest in k-space [as before]
- Construct a function $F'(a_0, a, X, m_x, m_y)$; its value is the Y value that would be obtained if *a* is the true alignment-parameter vector while the g function was generated using $a_0$. For $a = a_0$, we have F' = 0. This function may use interpolation, as in the method described by Figure 11.
- Perform a least-squares minimization (e.g., according the equation at the top of this paragraph), i.e., a curve fit, to find the best-fitting parameter vector *a*. Use any standard algorithm for curve fitting (e.g., Levenberg-Marquardt).

Bayesian methods can be used for this embodiment, also.

When optimizing for three degrees of freedom *(x* and y components of $r_0$ and $\alpha_z$), it has been shown that convergence using methods described herein can be achieved very quickly, e.g., the fitted position may be stable to < 10 nm and the angle to < 10 $\mu$rad after only two iterations.

As has already been stated, there may be more than one detector for detecting the diffraction pattern. If so, and the relative positions of the two or more detectors are fixed and known, the concepts disclosed herein are directly applicable. If relative positions are not known accurately, the described methods can be applied to each detector separately.

It may be appreciated that the pupil representation illustrated in Figure 10 and the corresponding transformation method may also be useful in the context of data-driven parameter inference methods in addition to physics-based methods. For example, if tool alignment drifts, this representation may be used to eliminate the impact of this drift from the signal.

Further embodiments are disclosed in the subsequent numbered clauses:

1. A method of determining an illumination-detection system alignment of an illumination-detection system describing alignment of at least one detector and/or measurement illumination of a metrology apparatus in terms of two or more illumination-detection system alignment parameters, each illumination-detection system alignment parameter relating to a respective degree of freedom for aligning the detector and/or the measurement illumination; the method comprising:

   obtaining a diffraction pattern relating to diffraction of broadband radiation from a structure;
   transforming each of one or more diffraction orders of the diffraction pattern to a respective region coordinate system, each region coordinate system comprising a first axis and a second axis, each region coordinate system being such that said first axis is aligned in relation to a direction of an intensity metric of each transformed diffraction order; and
   determining illumination-detection system alignment parameter values for the illumination-detection system alignment parameters such that the position of said intensity metric of each said diffraction pattern substantially corresponds to an expected configuration in said region coordinate system.

2. A method as claimed in clause 1, wherein the diffraction pattern comprises a two-dimensional diffraction pattern and the structure comprises a two-dimensional periodic structure for performing metrology in two dimensions of a structure plane.

3. A method as claimed in clause 1 or 2, wherein the method comprises fitting three or more illumination-detection system alignment parameters.

4. A method as claimed in clause 1 or 2, wherein the method comprises fitting six or more illumination-detection system alignment parameters.

5. A method as claimed in any preceding clause, wherein the degrees of freedom for aligning the detector and/or measurement radiation comprise six detector alignment degrees of freedom: the three directions of the detector coordinate system and rotations around each of these directions.

6. A method as claimed in any preceding clause, wherein the degrees of freedom for aligning the detector and/or measurement radiation comprise two illumination alignment degrees of freedom:
illumination azimuth and illumination angle of incidence.

7. A method as claimed in any preceding clause, wherein the intensity metric is peak intensity of each diffraction order.

8. A method as claimed in any preceding clause, wherein the expected configuration comprises a substantially straight line in said region coordinate system.

9. A method as claimed in clause 8, wherein said straight line is aligned with said first axis of said region coordinate system, and the step of determining illumination-detection system alignment parameter values comprises minimizing a distance from said first axis of the position of said intensity metric within said region coordinate system.

10. A method as claimed in any preceding clause, wherein said step of transforming one or more diffraction orders of the diffraction pattern to a region coordinate system comprises:

   transforming said diffraction pattern from a detector coordinate system to a pupil coordinate system;
   identifying a region of interest for each of said one or more diffraction orders to be transformed, said region of interest including its respective diffraction order; and
   performing a mapping of a function describing each of said one or more diffraction orders in said pupil coordinate system to a function describing each of said one or more diffraction orders in said region coordinate system.

11. A method as claimed in clause 10, wherein each region of interest is rectangular.

12. A method as claimed in clause 10 or 11, wherein said mapping is performed as one of:

   a mean or weighted mean along the second axis of said region coordinate system,
   the median along the second axis of said region coordinate system;
   the modus along the second axis of said region coordinate system;
   a value obtained by fitting to a function describing a known peak shape.

13. A method as claimed in any preceding clause, comprising determining coordinates for said intensity metric in said region coordinate system; and

minimizing values of the second axis coordinate.

14. A method as claimed in clause 13, wherein said minimizing values step comprises constructing a Jacobian of partial derivatives describing the sensitivity of the second axis coordinate with each alignment parameter.

15. A method as claimed in clause 13 or 14, wherein said minimizing values step is performed iteratively beginning with an initial estimate for the alignment parameters and iteratively optimizing the alignment parameters until convergence.

16. A method as claimed in any of clauses 13 to 15, wherein said minimizing values step comprises a Levenberg-Marquardt minimization, a Nelder-Mead minimization, a Gauss-Newton minimization or other sum-of-squares minimization.

17. A method as claimed in any of clauses 13 to 15, comprising obtaining is prior knowledge of the probability distribution of the illumination-detection system alignment parameters; and wherein said minimizing values step comprises a Bayesian inference minimization.

18. A method as claimed in any preceding clause, wherein said one or more diffraction orders comprises the one or more diffraction orders having greatest intensity within the diffraction pattern.

19. A method as claimed in any preceding clause, wherein the one or more diffraction orders comprises at least two first-order diffraction orders.

20. A method as claimed in any preceding clause, wherein the one or more diffraction orders comprises at least three first-order diffraction orders.

21. A computer program comprising computer readable instruction operable to perform at least the processing and determining a position steps of the method of any of clauses 1 to 20.

22. A processor and associated storage medium, said storage medium comprising the computer program of clause 21 such that said processor is operable to perform the method of any of clauses 1 to 20.

23. A metrology device operable to perform the method of any of clauses 1 to 20.

24. A metrology device as claimed in clause 23 comprising a detector, wherein said method is performed to determine an illumination-detection system alignment of the detector and/or measurement radiation;

wherein said processor is further operable to determine a parameter of interest for a measurement performed using the metrology device based on the determined illumination-detection system alignment.

25. A lithographic cell comprising the metrology device of clause 23.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays.

While specific embodiments have been described above, it will be appreciated that one or more of the features in one embodiment may also be present in a different embodiment and that features in two or more different embodiments may also be combined.

**Claims**

1. A method of determining an illumination-detection system alignment of an illumination-detection system describing alignment of at least one detector and/or measurement illumination of a metrology apparatus in terms of two or more illumination-detection system alignment parameters, each illumination-detection system alignment parameter relating to a respective degree of freedom for aligning the detector and/or the measurement illumination; the method comprising:

   obtaining a diffraction pattern relating to diffraction of a broadband radiation from a structure;
   transforming each of one or more diffraction orders of the diffraction pattern to a respective region coordinate system, each region coordinate system comprising a first axis and a second axis, each region coordinate system being such that said first axis is aligned in relation to a direction of an intensity metric of each transformed diffraction order; and
   determining illumination-detection system alignment parameter values for the illumination-detection system alignment parameters such that the position of said intensity metric of each said diffraction pattern substantially corresponds to an expected configuration in said region coordinate system.

2. A method as claimed in claim 1, wherein the diffraction pattern comprises a two-dimensional diffraction pattern and the structure comprises a two-dimensional periodic structure for performing metrology in two dimensions of a structure plane.

3. A method as claimed in any preceding claim, wherein the intensity metric is peak intensity of each diffraction order.

4. A method as claimed in any preceding claim, wherein the expected configuration comprises a substantially straight line in said region coordinate system.

5. A method as claimed in claim 4, wherein said straight line is aligned with said first axis of said region coordinate system, and the step of determining illumination-detection system alignment parameter values comprises minimizing a distance from said first axis of the position of said intensity metric within said region coordinate system.

6. A method as claimed in any preceding claim, wherein said step of transforming one or more diffraction orders of the diffraction pattern to a region coordinate system comprises:

   transforming said diffraction pattern from a detector coordinate system to a pupil coordinate system;
   identifying a region of interest for each of said one or more diffraction orders to be transformed, said region of interest including its respective diffraction order; and
   performing a mapping of a function describing each of said one or more diffraction orders in said pupil coordinate system to a function describing each of said one or more diffraction orders in said region coordinate system.

7. A method as claimed in claim 6, wherein said mapping is performed as one of:

a mean or weighted mean along the second axis of said region coordinate system,
the median along the second axis of said region coordinate system;
the modus along the second axis of said region coordinate system;
a value obtained by fitting to a function describing a known peak shape.

8. A method as claimed in any preceding claim, comprising determining coordinates for said intensity metric in said region coordinate system; and

minimizing values of the second axis coordinate,
wherein optionally said minimizing values step comprises constructing a Jacobian of partial derivatives describing the sensitivity of the second axis coordinate with each alignment parameter.

9. A method as claimed in claim 8, wherein said minimizing values step is performed iteratively beginning with an initial estimate for the alignment parameters and iteratively optimizing the alignment parameters until convergence.

10. A method as claimed in any of claims 8 and 9, comprising obtaining is prior knowledge of the probability distribution of the illumination-detection system alignment parameters; and wherein said minimizing values step comprises a Bayesian inference minimization.

11. A method as claimed in any preceding claim, wherein the one or more diffraction orders comprises at least two first-order diffraction orders.

12. A method as claimed in any preceding claim, wherein the one or more diffraction orders comprises at least three first-order diffraction orders.

13. A computer program comprising computer readable instruction operable to perform at least the processing and determining a position steps of the method of any of claims 1 to 12.

14. A processor and associated storage medium, said storage medium comprising the computer program of claim 13 such that said processor is operable to perform the method of any of claims 1 to 12.

15. A metrology device operable to perform the method of any of claims 1 to 12.

Fig. 1

Fig. 2

Fig. 3

Fig. 4

Fig. 5

Fig. 6

(a)

(b)

(c)

(d)

Fig. 7

Fig. 8

Fig. 9

(0,1)

(-1,0)    (1,0)

(0,-1)

Fig. 10

Fig. 11

Rol

(1,0)

Fig. 12

$k_y$

X

Rol

$k_x$

Y

Fig. 13

Y

$J_{i1}$

$J_{i2}$

X

$J_{i3}$

Fig. 14

Europäisches
Patentamt

European
Patent Office

Office européen
des brevets

# EUROPEAN SEARCH REPORT

Application Number

EP 22 18 0144

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 3 851 915 A1 (ASML NETHERLANDS BV [NL]) 21 July 2021 (2021-07-21) * paragraphs [0041] - [0054], [0090] - [0106]; figures 5,10 * | 1-15 | INV. G03F7/20 G01N23/201 |
| A | WO 2021/121906 A1 (ASML NETHERLANDS BV [NL]) 24 June 2021 (2021-06-24) * paragraphs [0046] - [0056], [0099] - [0115]; figures 5,10 * | 1-15 | |

**TECHNICAL FIELDS SEARCHED (IPC)**

G03F
G01N

The present search report has been drawn up for all claims

| Place of search | Date of completion of the search | Examiner |
|---|---|---|
| Munich | 9 December 2022 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 18 0144

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2022

| Patent document cited in search report | | Publication date | Patent family member(s) | | | Publication date |
|---|---|---|---|---|---|---|
| EP 3851915 | A1 | 21-07-2021 | NONE | | | |
| WO 2021121906 | A1 | 24-06-2021 | CN | 114902139 | A | 12-08-2022 |
| | | | IL | 293749 | A | 01-08-2022 |
| | | | KR | 20220103772 | A | 22-07-2022 |
| | | | TW | 202138927 | A | 16-10-2021 |
| | | | TW | 202227905 | A | 16-07-2022 |
| | | | WO | 2021121906 | A1 | 24-06-2021 |

EPO FORM P0459

For more details about this annex : see Official Journal of the European Patent Office, No. 12/82

**EP 4 296 779 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B

- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1
- WO 2017186483 A1

**Non-patent literature cited in the description**

- **LEMAILLET et al.** Intercomparison between optical and X-ray scatterometry measurements of FinFET structures. *Proc. of SPIE,* 2013, 8681

32